# EUROPEAN PATENT APPLICATION

(11) **EP 3 992 328 A1**
(43) Date of publication of application: **04.05.2022**
(21) Application number: 20205239.5
(22) Date of filing: 02.11.2020
(51) Int. Cl.: C23C 16/455, B65H 23/04, C23C 16/54

(54) **LAYER DEPOSITION DEVICE**

(71) Applicant: SMIT Thermal Solutions, 5657 EB Eindhoven (NL)
(72) Inventor: DU PAU, Cornelis Petrus, 5627MT Eindhoven (NL)
(74) Representative: Patentbüro Paul Rosenich AG

(57) **Abstract**

The invention relates to a layer deposition device (1) for depositing material onto a web (2), particularly an atomic layer deposition (ALD) device, comprising:
- a depositing area (3) with at least one depositing head (30),
- a transport system (4) for transporting the web (2) along a transport path (5) through the depositing area (3), and
- supporting means for holding the web (2) relative to the depositing head (30),
wherein the depositing head (30) has a material outlet side (29) facing the transport path (5), characterized in that the supporting means comprises at least one acoustic levitation device (17) with an acoustic wave generator (18) connected to a sonotrode (19) for generating acoustic waves effecting the web (2) to levitate at a distance, preferably a predetermined distance, to the material outlet side (29) of the depositing head (30), wherein preferably the acoustic wave generator (18) is an ultrasonic transducer.

## Description

The invention relates to a layer deposition device for depositing material onto a web according to the preamble of claim 1. The invention also relates to a method of depositing material onto a web with a layer deposition device.#The invention may be particularly used in atomic layer deposition systems and methods for atomic layer deposition (ALD) onto a web or substrate, in particular spatial atomic layer deposition (sALD).#

Atomic layer deposition (ALD) systems are known in general. For example, WO2018169680A1 describes a deposition system with moveable-position web guides, wherein a motion actuator system synchronously moves a position of a first and a second moveable-position web guide such that they move forward and backward according to a defined oscillating motion pattern while maintaining a constant distance between the first and second moveable-position web guides thus moving the web back and forth underneath the depositing head. The latter is done so that many layers can be formed on top of each other.

EP2122005B1 discloses a deposition system for thin film deposition of a solid material onto a substrate. A delivery head delivers gaseous material to a substrate. The delivery head comprises an output face having a plurality of output openings and facing the substrate, wherein first, second, and third gaseous materials are simultaneously exhausted from the output openings. The delivery head also comprises a plurality of inlet ports for receiving first, second, and third gaseous material, respectively. A substantially uniform distance between the output face of the delivery head and the substrate surface is maintained, in that pressure generated due to flows of the gaseous materials from the delivery head to the substrate surface provides at least part of the force separating the output face of the delivery head from the surface of the substrate.

There remains a need for improving layer depositing systems, particularly (s)ALD systems, for example in relation to one or more of the following characteristics: processing speed, processing efficiency, processing cleanliness, processing reliability, versatility in terms of material and product properties, product quality, return on investment, compactness and ease of use.

In particular, prior art deposition systems do not provide sufficient depositing quality which, however, would be essential for a plurality of applications. The uniform spatial distribution of material on the web, a constant and precise coating thickness and its reproducibility are important aspects and significantly depend on different surrounding circumstances, such as absolute temperature, temperature changes during the process, humidity, fluctuations caused by device components, etc..

Also state of the art systems that use gas bearings are expensive in use because of the pressurized air or gas needed.

It is therefore an object of the invention to provide a layer deposition device which overcomes at least some of the problems of prior art and which allows for achieving a more uniform spatial coating distribution and/or also a precise and reproducible coating thickness. The resulting atomic layer deposition device should be as simple as possible and cost-effective with respect to construction and operation.

The object is achieved by a layer deposition device according to the preamble of claim 1, in that the supporting means comprises at least one acoustic levitation device with an acoustic wave generator connected to a sonotrode for generating acoustic waves effecting the web to levitate at a distance to the material outlet side of the depositing head, wherein preferably the acoustic wave generator is an ultrasonic transducer.

The principle of the present invention consists in the fact that the web - when moving through the depositing area and/or during a standstill - is stiff supported by acoustic waves. Acoustic levitation takes advantage of the non-linear properties of AC sound pressure to cause objects to levitate. DC (sound or gas) pressure may be used additionally to stabilize the position. E.g. a vacuum pre-load on one side of the web and/or a over-pressure one the other side of the web may be used to define and stabilize a stiff work point of the levitation height.

The position (or level) of the web relative to the material outlet side of the depositing head may be adjusted in an extremely precise way when using an acoustic levitation device as contactless supporting means. Moreover, the distance (with other words: the width or height (used interchangeably) of the gap) between the web and the material outlet side may be held highly constant, not only temporally but also spatially. An important advantage consists in the fact that holding the web by means of acoustic pressure is more or less independent from other impacts, such as the material flow out from the material outlet side or other surrounding circumstances, such as absolute temperature, temperature changes during the process, humidity, fluctuations caused by device components, etc.. At the same time the web is supported in a contact-free manner, thus protecting the back side of the web thus minimizing the generation of polluting particles.

The independence of the position (or level) of the web relative to the material outlet side from the material flow (which deposits on the web) is very advantageous. In contrast to prior art, fluctuations in the material flow (e.g. needed for different recipes) do not adversely affect the resulting quality of the deposited layer, since the distance between web and material outlet side do not change.

Moreover the acoustic waves have an advantageous impact (acoustophoresis) on the particles moving from the depositing head towards the web. As a result, the particle distribution on the web becomes more uniform and smoother.

The at least one drive of the transport system effects the transport movement of the web along the transport path. Preferably, the drive is configured for inducing a substantially continuous transport movement of the web. The drive may act on a roller of the transport system - preferably on a supply roller, on which the web is rolled up. The roller engages the web and induces the transport movement of the web.

The web - which may be a foil, a sheet, a mesh, a tissue, etc. - constitutes the substrate of the layer depositing process, i.e. the substrate the layer is deposited on.

The depositing area is that area in which material is deposited onto the web by the layer depositing, e.g. ALD or sALD, process. The depositing area may comprise a depositing head from which material gets released towards the web. The invention may be used for any kind of layer depositing process. Examples are chemical vapour deposition (CVD), atomic layer deposition (ALD), spatial atomic layer deposition (sALD), etc..

A variant of an ALD process known as spatial atomic layer deposition (sALD) employs a substantially continuous gaseous material distribution from a deposition head. As distributed from the deposition head, the gaseous precursors are separated in space by the flow of an inert gas, rather than being separated in time. Such systems include beside a deposition head a so-called gas-bearing backer (for creating a counter pressure on the web). Deposition head and gas-bearing backer are usually arranged opposite to each other, wherein the web is transported through the space formed between deposition head and gas-bearing backer. In such an embodiment the depositing area is located between deposition head and gas-bearing backer.

If multiple gases are used, such as is the case for sALD, normally separating gasses and exhausts are used so that the reactive gases do not come in contact with each other before they are deposited on the web, where they should react. In such a case, the depositing area is normally located between two outer outlets for separating gasses.

An example for such a depositing area comprising deposition head and gas-bearing backer is e.g. described in WO2018169680A1 or EP2122005B1, which documents are incorporated herein by reference.

The inventive device and method is suitable for different types of webs such as foils - particularly foils with a small E-modulus, such as a polyurethane (PE) foil -, (metal) meshes, woven or non-woven fabrics, particularly webs that easily contract in traverse direction. Also, the optimal tension during deposition may differ significantly for different web types. Since the frequencies used are very high, even foils with open pores can be supported.

Typical frequencies of 20 to 200 kHz, preferably 20 to 100 kHz, may be used. The acoustic waves may have wavelengths of 30mm to 300 mm, preferably 50mm to 200mm. The waves may have an amplitude of 1µm to 15 µm, preferably between 5µm and 10µm. The size of the deposition area may be - in an example - around 1 square meter. The continuous (DC component) foil speed during depositing may be - in an preferred example - 0.04 m/s to 0.3 m/s. For sALD the superimposed oscillating (AC component) speed may have - in a preferred example - a maximum of 0.5 m/s to 3 m/s 1.2 meters per second. In an preferred example the foil may be tensioned with a tension of 30 to 300 N/m, preferably with a tension of 100 to 200 N/m (measured as force per unit of width of the foil), during depositing.

A further advantage of the invention consists in the fact that the acoustic waves have an advantageous impact on the stiffness of the web. I.e. by adjusting the operational parameters of the acoustic levitation device (e.g. frequency, pressure (vacuum) level, wave length, wave amplitude, etc.) also the support stiffness of the web in the depositing area may be adjusted/optimized independent of the tension in the foil.

Better control of support stiffness can enable also better control of a position of the substrate web plane in the depositing area, i.e. adjacent the depositing head. Web support stiffness, web tension and/or web position at the deposition head can be critical parameters with respect to many aspects of performance of a deposition (particularly sALD) system. Thus, depositing system is provided wherein at least one of processing speed, processing efficiency, processing reliability, versatility in terms of material and product properties, product quality, return on investment, compactness and ease of use is improved. Moreover, the position of the web plane can be better controlled since with the inventive system environmental (thermal) influences, stress and strain of the web can be counteracted by the stiff web support.

An optional reciprocating system of the layer deposition device may impose on the web a reciprocating movement along the transport path in the depositing area, such that the reciprocating movement (induced by the reciprocating system) superimposes on the transport movement (induced by the transport system) of the web. With other words: By means of the reciprocating system the (substrate) web can be moved alternatingly in opposite directions along the transport path. In such a way a compact and economic ALD or spatial ALD device can be provided. By additionally controlling and/or adjusting (varying) the tension of the web in the depositing area the process is better controllable and more stable.

In a preferred embodiment the sonotrode is formed by at least a part of the depositing head. With other words: the depositing head or part thereof may be used as a sonotrode. Here, no additional element is needed, since the depositing head itself is used to emit the acoustic waves induced by the acoustic wave generator. Also the acoustic velocity of the waves in the gasses between the deposition head and the web may positively influence their distribution and promote diffusion.

In a preferred embodiment the layer deposition device comprises a pressure adjusting means, preferably comprising a under-pressure generator and/or a over-pressure generator, for adjusting the gas pressure in the depositing area, preferably for generating in the depositing area a pressure difference between the two sides of the web when being transported along the transport path through the depositing area. With a (gas) pressure adjusting means adjusting the gas pressure on at least one side of the web the positional working point (i.e. the levitation height) may be accurately adjusted.

Here, e.g. normal DC air or gas pressure may be used to press (over-pressure from one side of the web) and/or to draw (under-pressure on the other side of the web) the web towards the sonotrode. Therefore, e.g. a vacuum source may be provided connected to holes in the sonotrode. Alternatively or additionally, the whole depositing area (or depositing chamber) may be put under over-pressure. Apparently, the pressure under the web (i.e. between web and sonotrode) may be held essentially constant and is not altered by the over-pressure or the vacuum created directly above the holes. Since the holes are very small (may be e.g. 0.2mm in diameter or smaller), the stiffness of the foil will keep the foil flat above the holes, so that the deposited layer is not impaired.

In a preferred embodiment the pressure adjusting means comprises openings formed in the sonotrode and facing the transport path.

In a preferred embodiment the sonotrode is arranged opposite to the material outlet side of the depositing head, wherein the transport path extends between the material outlet side and the sonotrode, wherein preferably the height of the gap formed between the sonotrode and the material outlet side is adjustable and/or is smaller than 1mm and/or larger than 20 µm (preferably between 100µm and 600µm). Here, the sonotrode is formed by a separated or additional element which is arranged opposite to the depositing head. The element acting as a sonotrode may be adjusted independently from the depositing head. In this embodiment the depositing head may be kept - to a great extent - free from acoustic waves. The sonotrode may be a metal plate, preferably with a thickness of 2 to 3 cm.

The term 'height' of the gap in the present application may be interchangeably used with 'width' of the gap or 'distance' between (two) parts, elements or entities forming the gap in between. In particular, the term 'height' of the gap is used independent of a possible (spatial) orientation of the gap or of the parts, elements or entities forming the gap (i.e. without any restriction to a certain spatial orientation).

The sonotrode preferably has a length (in transport direction) larger than the length of the depositing head, preferably of at least 1.2 times the length of the depositing head, even more preferably of at least 1.5 times the length of the depositing head.

The sonotrode preferably has a width (perpendicular to the transport direction) larger than the width of the depositing head, preferably of at least 1.05 times the width of the depositing head, even more preferably of at least 1.1 times the width of the depositing head.

In a preferred embodiment the sonotrode side facing the transport path has - preferably in its overall extension - a smooth surface, preferably free from large discontinuities. The plane formed by the acoustic pressure by which the web is elevated then is also smooth. As a result the web is held, to a high degree, at a constant height, not only temporally but also spatially. If needed, vacuum holes may be provided in the smooth surface of the sonotrode for preloading the web.

In a preferred embodiment surface sections of the material outlet side of the depositing head and surface sections of the sonotrode side facing the transport path are essentially parallel to each other, wherein preferably the parallel sections extend at least over the whole depositing area (and possibly also beyond the depositing area). This allows a high degree of parallelism between the web and the material outlet side, which in turn assists a uniform material deposition on the web.

In a preferred embodiment the sonotrode is formed by a plate, wherein preferably the thickness of the plate is smaller than 3cm, preferably smaller than 2cm, and/or wherein preferably the sonotrode is supported by a plurality of legs, preferably adjustable in their height. A plate is particularly suitable for radiating acoustic waves in the direction perpendicular to the plate's plane (i.e. out of its flat surface).

In a preferred embodiment the extension of the sonotrode in transport direction of the transport path in the depositing area is larger, preferably at least 1.2 times larger, more preferred at least 1.5 times larger, than the extension of the material outlet side of the depositing head in transport direction of the transport path in the depositing area. In this embodiment it is ensured that the plane in which the web is - more or less fixedly - kept, extends in a plane which is parallel to the surface defined by the material outlet side, not only in the central region but also in the peripheral regions of the depositing head. Since the materials discharged from the depositing head also need to be separated on the lateral sides, this additional space near the edges of the web, can simultaneously be used for this. Also the edges need to be held in plane so that they do not vibrate.

In a preferred embodiment the extension of the sonotrode transverse to the transport direction of the transport path in the depositing area is larger, preferably at least 5% larger, more preferred at least 10% larger, than the extension of the material outlet side of the depositing head transverse to the transport direction of the transport path in the depositing area. This feature also improves the geometric uniformity of the acoustic node supporting the web.

In a preferred embodiment the layer deposition device comprises a controller in control communication with the acoustic levitation device, for controlling the acoustic levitation device, particularly for adjusting the frequency, the wave length and/or the amplitude of the emitted acoustic waves. In such a way the distance (or gap) between the web and the surface of the material outlet side may be adjusted in a very exact manner. Preferably, an adjustment of operational parameters of the acoustic levitation device (by the controller) is performed during the operation of the depositing head and/or during movement of the web through the depositing area. This may be done in dependence of sensor data of a sensor which e.g. monitors the gap and/or at least one characteristic of the web and/or the layer deposited on the web.

In a preferred embodiment the controller is adapted to control the acoustic levitation device in dependence of sensor data of at least one sensor, wherein preferably the sensor data are a - direct or indirect - measure of the gap formed between the web and the material outlet side of the depositing head and/or of a characteristic of the web (e.g. the tension or stiffness) and/or of a characteristic of the deposited layer, particularly a thickness, a degree of uniformity and/or a surface quality of the deposited layer. A pressure sensor may be provided under the depositing head. If the height of the gap formed between the web and the material outlet side of the depositing head becomes smaller, the pressure will increase.

In a preferred embodiment the controller of the layer deposition device is in control communication with the transport system and the depositing head, wherein preferably the acoustic wave generator is controllable by the controller independently of the transport system (particularly independent of the transport velocity) and/or independently of the depositing head, particularly independently of the material type and/or material flow out of the material outlet side of the depositing head.

In a preferred embodiment the layer deposition device comprises a reciprocating system for imposing on the web a reciprocating movement along the transport path in the depositing area, wherein preferably the acoustic wave generator is controllable by the controller independently of the reciprocating system.

The possibility of independent control of the acoustic levitation device allows for adjusting and/or optimizing the system for material deposition. I.e. the acoustic levitation device provides additional parameters for the forming of the layer.

In a particularly preferred embodiment the layer deposition device comprises a tension adjustment system for adjusting the tension of the web in the depositing area. Such a tension adjustment system may be provided as a separate system which may be independent of the acoustic levitation device. The tension adjustment system may be realized by means of web interacting units, preferably of web interacting units of a reciprocating system. In this way any fluctuations in the tension of the web may be compensated by the tension adjustment system. The tension and thus also the spatial precision of the deposition process is better and contemporarily controllable. Also, the tension can be adjusted to the type of web and/or the tension can be controlled to compensate web acceleration.

The object is also achieved with a method of depositing material onto a web, with a layer deposition device comprising a depositing area with at least one depositing head, preferably according to one of the preceding embodiments,
the method comprising the steps of:
(a) transporting the web - preferably by means of a transport system - along a transport path through the depositing area, and
(b) holding the web relative to the depositing head, preferably during operation of the depositing head and/or during the transport movement of the web according to step (a),
wherein holding the web according to step (b) comprises generating acoustic waves, preferably ultrasonic waves, effecting the web to levitate at a (defined) distance to a material outlet side of the depositing head.

In a preferred embodiment the support stiffness of the web per unit of area in the depositing area, which stiffness is effected by the acoustic wave pressure, is greater than 50 Pa/µm and preferably smaller than 100 Pa/ µm. In such a manner the position of the web relative to the depositing head becomes more or less independent of the material flow out of the material outlet side of the depositing head.

In a preferred embodiment the height of the gap formed between the web and the material outlet side of the depositing head is smaller than 1mm, preferably smaller than 0.5mm, and/or wherein the height of the gap formed between the web and the material outlet side of the depositing head is larger than 0.02mm, preferably larger than 0.1mm.

In a preferred embodiment the acoustic wave generator is controlled independently of the transport system and/or independently of the depositing head, particularly independently of the material type and/or material flow out of the material outlet side of the depositing head.

Further embodiments of the invention are indicated in the figures and in the dependent claims. The list of reference marks forms part of the disclosure. The invention will now be explained in detail by the drawings. In the drawings:
- Fig. 1: shows an embodiment of a layer deposition device,
- Fig. 2: shows in an embodiment of a layer deposition device,
- Fig. 3: shows a further embodiment of a layer deposition device,
- Fig. 4: shows a third embodiment of a layer deposition device,
- Fig. 5: shows a fourth embodiment of a layer deposition device,
- Fig. 6: shows a web with a layer deposited on it and a sensor for monitoring the deposited layer
- Fig. 7: shows in a top view a deposition heat and the sonotrode
- Fig. 8: shows an embodiment of the invention with a pressure adjusting means.

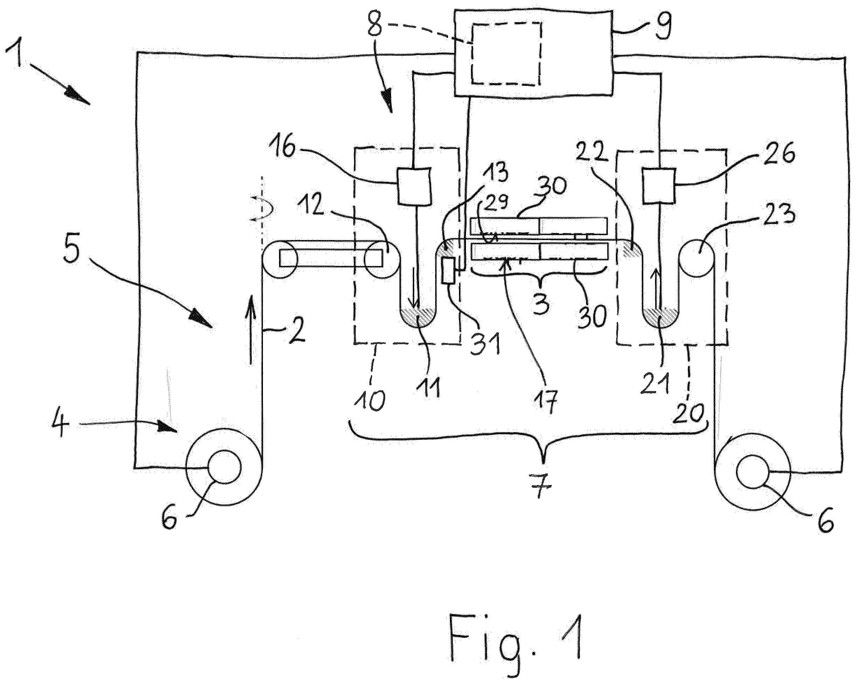

Fig. 1 shows a layer deposition device 1, particularly an atomic layer deposition device, for depositing material onto a web 2. The depositing heads 30 define a depositing area 3 in which material (from a gaseous phase) is deposited on the substrate web. The depositing head 30 has a material outlet side 29 facing the transport path 5.

A transport system 4 transports the web 2 along a transport path 5 through the depositing area 3. The transport system 4 comprises at least one drive 6 for effecting transport movement of the web 2. The transport system 4 further comprises rollers for driving and guiding the web through the (e.g. atomic) layer deposition device 1.

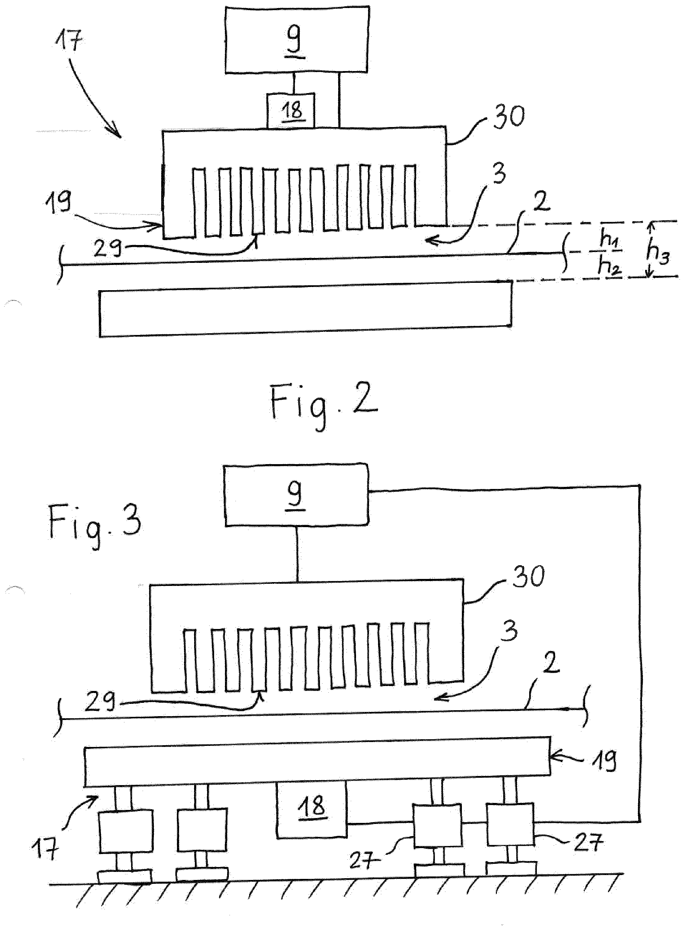

The layer deposition device 1 comprises a supporting means 17 for holding the web 2 relative to the depositing head 30. The supporting means comprises at least one acoustic levitation device 17 with an acoustic wave generator 18 (see figs. 2 to 6) connected to a sonotrode 19 for generating acoustic waves effecting the web 2 to levitate at a distance to the material outlet side 29 of the depositing head 30. It is preferred if the acoustic wave generator 18 is an ultrasonic transducer.

In the embodiment of Fig. 2 the acoustic wave generator is connected to the depositing head 30, i.e. the sonotrode 19 is formed by the depositing head 30 or a part thereof.

In the embodiments of Figs. 3-6 the sonotrode 19 is arranged - as a separate element - opposite to the material outlet side 29 of the depositing head 30, wherein the transport path 5 extends between the material outlet side 29 and the sonotrode 19. The height of the gap formed between the sonotrode 19 and the material outlet side 29 is adjustable (e.g. by means of adjustable legs 27 shown in Fig. 3).

Since the shape and size of the sonotrode 19 may differ, an intermediate layer between the acoustic wave generator 18 and the sonotrode 19 may be provided that ensures that the acoustic wave generator 18 can give off its energy efficiently without receiving back too much reflected energy. This may be seen as impedance matching for the oscillations coming from the acoustic wave generator(s) 18. This is known in the state of the art.

The sonotrode side facing the transport path 5 has - preferably in its overall extension - a smooth surface, preferably free from large discontinuities (such as holes).

As can be seen from Figs. 2-6 the surface of the material outlet side 29 of the depositing head 30 and the surface of the sonotrode side facing the transport path 5 may be essentially parallel to each other.

The sonotrode 19 of Fig. 3 is formed by a plate, wherein preferably the thickness of the plate is smaller than 3cm, preferably smaller than 2cm. As already mentioned the sonotrode 19 may be supported by a plurality of legs 27, preferably adjustable in their height.

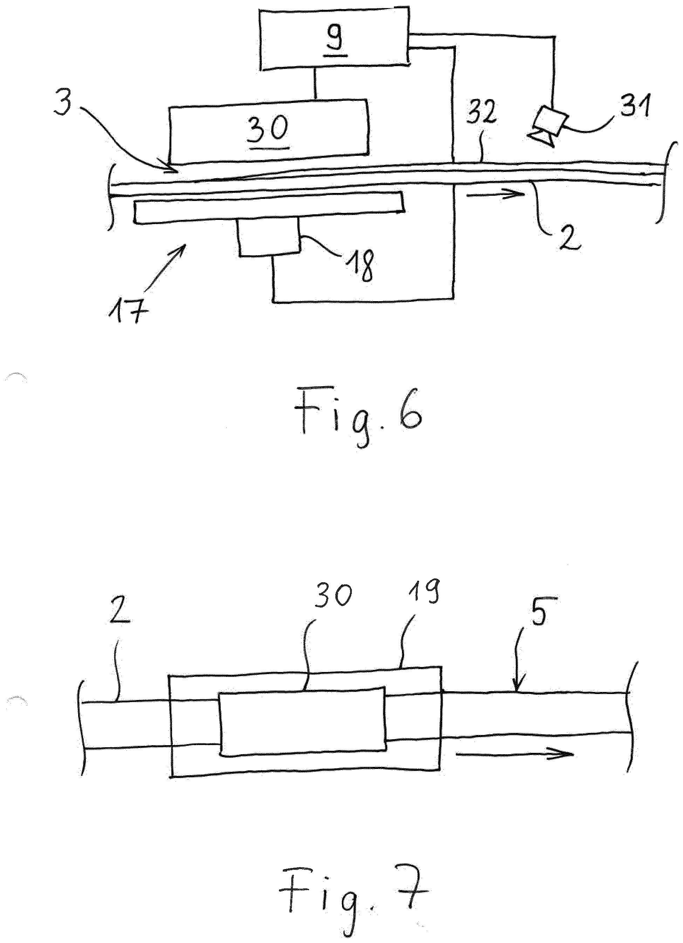

The extension of the sonotrode 19 in transport direction of the transport path 5 in the depositing area 3 is preferably larger (see e.g. Figs. 3 and 7), preferably at least 1.2 times larger, more preferred at least 1.5 times larger, than the extension of the material outlet side 29 of the depositing head 30 in transport direction (see arrow in Fig. 7) of the transport path 5 in the depositing area 3.

The extension of the sonotrode 19 transverse to the transport direction of the transport path 5 in the depositing area 3 is preferably larger (see Fig. 7), preferably at least 5% larger, more preferred at least 10% larger, than the extension of the material outlet side 29 of the depositing head 30 transverse to the transport direction see arrow in Fig. 7) of the transport path 5 in the depositing area 3.

As can be seen from Figs. 1-3 and 6 the layer deposition device 1 comprises a controller 9 in control communication with the acoustic levitation device 17, for controlling the acoustic levitation device 17, particularly for adjusting the frequency and/or the amplitude of the emitted acoustic waves.

The controller 9 may be adapted to control the acoustic levitation device 17 in dependence of sensor data of at least one sensor 31 (see Fig. 6), wherein preferably the sensor data are a - direct or indirect - measure of the gap formed between the web 2 and the material outlet side 29 of the depositing head 30 and/or of a characteristic of the deposited layer 32, particularly a thickness, a degree of uniformity and/or a surface quality of the deposited layer 32.

The controller 9 may be also in control-communication with the transport system 4 and the depositing head 30 (see Fig. 1), wherein preferably the acoustic wave generator 17 is controllable by the controller 9 independently of the transport system 4 (since they are de-coupled: transport direction and holding direction may make a 90° angle) and/or independently of the depositing head 30, particularly independently of the material type and/or material flow out of the material outlet side 29 of the depositing head 30.

In a preferred embodiment the layer deposition device 1 may comprise a reciprocating system 7 (Fig. 1) for imposing on the web 2 a reciprocating movement along the transport path 5 in the depositing area 3. The acoustic wave generator 17 may be controllable by the controller 9 independently of the reciprocating system 7.

The (optional) reciprocating system 7 may impose on the web 2 a back and forth movement (reciprocating movement) along the transport path 5 in the depositing area 3, such that the oscillating motion (induced by the reciprocating system 7) superimposes the transport movement (induced by the transport system 4) of the web 2. I.e. the web moves back and forth in the depositing area 3 while the transport system 4 induces a substantially continuous forward movement to the web or vice versa.

The (optional) reciprocating system 7 comprises a first web interacting unit 10 interacting with the web 2 at a first position of the transport path 5, the first position being upstream of the depositing area 3. The reciprocating system 7 also comprises a second web interacting unit 20 interacting with the web 2 at a second position of the transport path 5, the second position being downstream of the depositing area 3. The first and second web interacting units 10, 20 act synchronously in order to effect the reciprocating movement.

The layer deposition device 1 may further comprise a tension adjustment system 8 for adjusting the tension of the web 2 in the depositing area 3. The tension adjustment system 8 acts on the web 2 via at least one of the first and second web interacting units 10, 20.

The first web interacting unit 10 comprises a first controllable deflection member 11 for locally modifying the run of the web 2. The second web interacting unit 20 comprises a second controllable deflection member 21 for locally modifying the run of the web 2.

In the embodiments of Fig. 1 the controllable deflection members 11, 21 are moveable in a direction increasing or decreasing the length of the transport path of the web. In Fig. 1 the deflection members are moveable in vertical direction. However, in an alternate embodiment the deflection members may be designed to be moveable in a non vertical or even horizontal direction.

The first web interacting unit 10 comprises along the transport path 5 a first web positioning member 12 upstream of the first controllable deflection member 11 and a second web positioning member 13 downstream of the first controllable deflection member 11. The first controllable deflection member 11 is moveable relative to the first web positioning member 12 and to the second web positioning member 13.

The second web interacting unit 20 comprises along the transport path 5 a first web positioning member 22 upstream of the second controllable deflection member 21 and a second web positioning member 23 downstream of the second controllable deflection member 21, wherein the second controllable deflection member 21 is moveable relative to the first web positioning member 22 and to the second web positioning member 23.

Positioning members 11, 13, 21, 22 may comprise at least one acoustic levitation device 17 with an acoustic wave generator 18 connected to a sonotrode 19 for generating acoustic waves effecting the web 2 to levitate at a distance to it. In this way the web 2 can be supported in a contact-free manner. In this way no pressurized gas is needed at all for handling the web 2 and moving masses are minimized.

The controller 9 may be in control communication with the first web interacting unit 10 and the second web interacting unit 20. The first web interacting unit 10 comprises a first actuator 16 (e.g. drive or pump) for controlling the interaction of the first web interacting unit 10 with the web 2. The second web interacting unit 20 comprises a second actuator 26 for controlling the interaction of the second web interacting unit 20 with the web 2.

The first actuator 16 and the second actuator 26 may be controlled independently of each other, thereby allowing not only the reciprocating movement but also varying and even actively controlling the tension of the web 2 in the depositing area 3.

The first actuator 16 may be formed by a drive configured for locally modifying the run of the web 2 by moving the first controllable deflection member 11 (in Fig. 1 in vertical direction).

The invention also relates to a method of depositing material onto a web 2, comprising the steps of:
(a) transporting the web 2 - preferably by means of a transport system 4 - along a transport path 5 through the depositing area 3, and
(b) holding the web 2 relative to the depositing head 30, preferably during operation of the depositing head 30 and/or during the transport movement of the web 2 according to step (a).

Holding the web 2 according to step (b) comprises generating acoustic waves, preferably ultrasonic waves, effecting the web 2 to levitate at a distance to a material outlet side 29 of the depositing head 30.

The height of the gap formed between the web 2 and the material outlet side 29 of the depositing head 30 is preferably smaller than 1mm, preferably smaller than 0.5mm, and/or larger than 0.02mm, preferably larger than 0.1mm.

As already mentioned the acoustic wave generator 18 may be controlled independently of the transport system 4 and/or independently of the depositing head 30, particularly independently of the material type and/or material flow out of the material outlet side 29 of the depositing head 30.

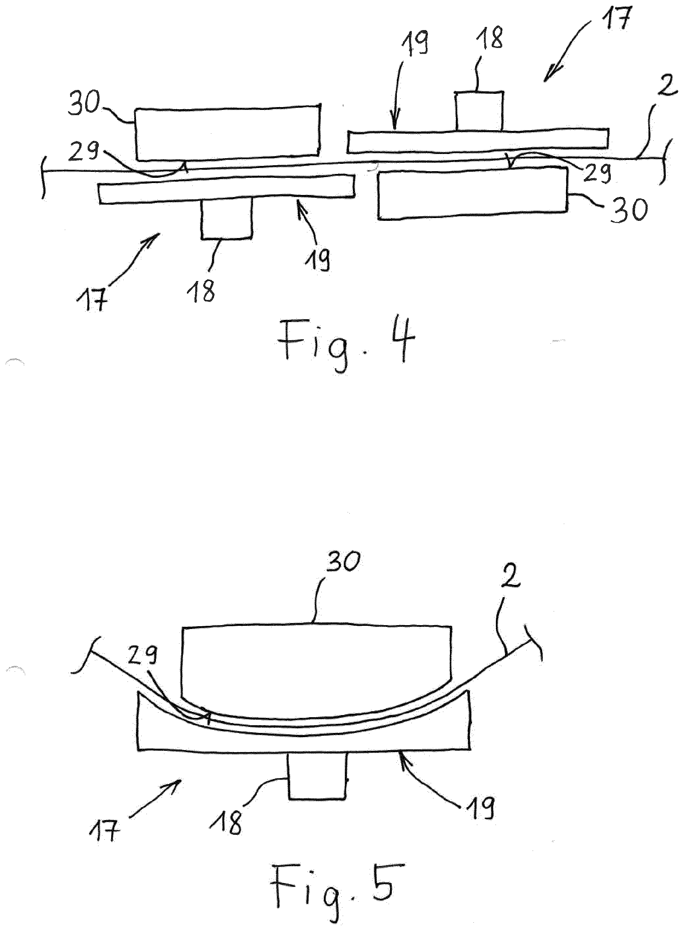

Since it is the pressure of the acoustic waves that determines the position of the web 2 (or actually its acceleration), all embodiments shown can also be rotated, e.g. so that the deposition area 3 (and the transport path 5) extends in vertical direction or indeed be non-planar as shown in fig. 5. This allows for additional design freedom.

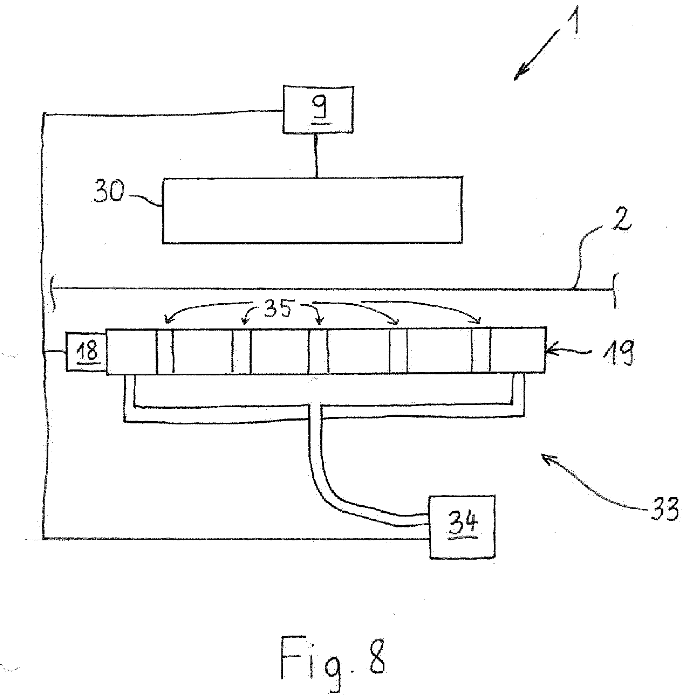

In the embodiment of Fig. 8 the layer deposition device 1 comprises a pressure adjusting means 33, here comprising an under-pressure generator 34 (e.g. a vacuum pump). In the present embodiment the pressure adjusting means 33 comprises openings 35 formed in the sonotrode 19 and facing the transport path 5. In an alternate embodiment (also) over-pressure in the area (ambient air) above the web 2 may be generated by an over-pressure generator (not shown). The adjusting means 33 is used for adjusting the gas pressure in the depositing area 3, preferably for generating in the depositing area 3 a pressure difference between the two sides of the web 2 when being transported along the transport path 5 through the depositing area 3. With a (gas) pressure adjusting means 33 the gas pressure on at least one side of the web and thus the positional working point (i.e. the levitation height) of the web may be adjusted. In the embodiment of Fig. 8 the under-pressure generated in the area below the web 2 counteracts the acoustic pressure of the sonotrode 19.

The invention is not restricted to these embodiments. Other variants will be obvious for the person skilled in the art and are considered to lie within the scope of the invention as formulated in the following claims. Individual features described in all parts of the above specification, particularly with respect to the figures may be combined with each other to form other embodiments and/or applied mutatis mutandis to what is described in the claims and to the rest of the description, even if the features are described in respect to or in combination with other features.

### List of reference signs

- 1: atomic layer deposition device
- 2: web
- 3: depositing area
- 4: transport system
- 5: transport path
- 6: drive
- 7: reciprocating system
- 8: tension adjustment system
- 9: controller
- 10: first web interacting unit
- 11: first controllable deflection member
- 12: first web positioning member
- 13: second web positioning member
- 16: first actuator
- 17: acoustic levitation device
- 18: acoustic wave generator
- 19: sonotrode
- 20: second web interacting unit
- 21: second controllable deflection member
- 22: first web positioning member
- 23: second web positioning member
- 26: second actuator
- 27: legs
- 29: material outlet side
- 30: depositing head
- 31: sensor
- 32: layer
- 33: pressure adjustment means
- 34: (under-pressure) generator
- 35: openings

## Claims

1. A layer deposition device (1) for depositing material onto a web (2), particularly an atomic layer deposition device, comprising:
- a depositing area (3) with at least one depositing head (30),
- a transport system (4) for transporting the web (2) along a transport path (5) through the depositing area (3), and
- supporting means (17) for holding the web (2) relative to the depositing head (30),
wherein the depositing head (30) has a material outlet side (29) facing the transport path (5), **characterized in that** the web supporting means comprises at least one acoustic levitation device (17) with an acoustic wave generator (18) connected to a sonotrode (19) for generating acoustic waves effecting the web (2) to levitate at a distance, preferably a predetermined distance, to the material outlet side (29) of the depositing head (30), wherein preferably the acoustic wave generator (18) is an ultrasonic transducer.

2. A layer deposition device according to claim 1, **wherein** the layer deposition device (1) comprises a pressure adjusting means (33), preferably comprising a under-pressure generator (34) and/or an over-pressure generator, for adjusting the gas pressure in the depositing area (3), preferably for generating in the depositing area (3) a pressure difference between the two sides of the web (2) when being transported along the transport path (5) through the depositing area (3), **wherein preferably** the pressure adjusting means (33) comprises openings (35) formed in the sonotrode (19) and facing the transport path (5) and/or wherein preferably the pressure difference exerts a force on the web (2) toward the sonotrode (19).

3. A layer deposition device according to claim 1 or 2, **wherein** the sonotrode (19) is formed by at least a part of the depositing head (30).

4. A layer deposition device according to one of the preceding claims, **wherein** the sonotrode (19) is arranged opposite to the material outlet side (29) of the depositing head (30), wherein the transport path (5) extends between the material outlet side (29) and the sonotrode (19), wherein preferably the height of the gap formed between the sonotrode (19) and the material outlet side (29) is adjustable and/or is smaller than 1mm and/or is larger than 20 µm.

5. A layer deposition device according to one of the preceding claims, **wherein** the sonotrode side facing the transport path (5) has - preferably in its overall extension and/or preferably in the section of the transport path (5) extending adjacent the depositing area (3) - a smooth surface, preferably free from discontinuities.

6. A layer deposition device according to one of the preceding claims, **wherein** surface sections of the material outlet side (29) of the depositing head (30) and surface sections of the sonotrode side facing the transport path (5) are essentially parallel to each other, wherein preferably the parallel surface sections extend at least over the whole depositing area (3).

7. A layer deposition device according to one of the preceding claims, **wherein** the sonotrode (19) is formed by a plate, wherein preferably the thickness of the plate is smaller than 3cm, preferably smaller than 2cm, and/or wherein preferably the sonotrode is supported by a plurality of legs (27), preferably adjustable in their height, wherein preferably the legs are matched to the acoustic wave generator (18) so that the latter can function efficiently.

8. A layer deposition device according to one of the preceding claims, **wherein** the extension of the sonotrode (19) in transport direction of the transport path (5) in the depositing area (3) is larger, preferably at least 1.2 times larger, more preferred at least 1.5 times larger, than the extension of the material outlet side (29) of the depositing head (30) in transport direction of the transport path (5) in the depositing area (3).

9. A layer deposition device according to one of the preceding claims, **wherein** the extension of the sonotrode (19) transverse to the transport direction of the transport path (5) in the depositing area (3) is at least as large, preferably larger, preferably at least 5% larger, more preferred at least 10% larger, than the extension of the material outlet side (29) of the depositing head (30) transverse to the transport direction of the transport path (5) in the depositing area (3).

10. A layer deposition device according to one of the preceding claims, **wherein** the layer deposition device (1) comprises a controller (9) in control communication with the acoustic levitation device (17), for controlling the acoustic levitation device (17), particularly for adjusting the frequency, the wavelength and/or the amplitude of the emitted acoustic waves.

11. A layer deposition device according to claim 10, **wherein** the controller (9) is adapted to control the acoustic levitation device (17) in dependence of sensor data of at least one sensor (31), wherein preferably the sensor data are a - direct or indirect - measure of the gap formed between the web (2) and the material outlet side (29) of the depositing head (30) and/or of a characteristic of the web (2) and/or of a characteristic of the deposited layer (32), particularly a thickness, a degree of uniformity and/or a surface quality of the deposited layer (32).

12. A layer deposition device according to one of the preceding claims, **wherein** the controller (9) of the layer deposition device (1) is in control communication with the transport system (4) and the depositing head (30), wherein preferably the acoustic wave generator (17) is controllable by the controller (9) independently of the transport system (4) and/or independently of the depositing head (30), particularly independently of the material type and/or material flow out of the material outlet side (29) of the depositing head (30).

13. A layer deposition device according to one of the preceding claims, **wherein** the layer deposition device (1) comprises a reciprocating system (7) for imposing on the web (2) a reciprocating movement along the transport path (5) in the depositing area (3), wherein preferably the acoustic wave generator (17) is controllable by the controller (9) independently of the reciprocating system (7).

14. Method of depositing material onto a web (2), with a layer deposition device (1) comprising a depositing area (3) with at least one depositing head (30), preferably according to one of the preceding claims,
the method comprising the steps of:
(a) transporting the web (2) - preferably by means of a transport system (4) - along a transport path (5) through the depositing area (3), and
(b) holding the web (2) relative to the depositing head (30), preferably during operation of the depositing head (30) and/or during the transport movement of the web (2) according to step (a), **characterized in that** holding the web (2) according to step (b) comprises generating acoustic waves, preferably ultrasonic waves, effecting the web (2) to levitate at a distance, preferably a predetermined distance, to a material outlet side (29) of the depositing head (30).

15. Method according to claim 14, **wherein**
the height (h₁) of the gap formed between the web (2) and the material outlet side (29) of the depositing head (30) is smaller than 1 mm, preferably smaller than 0.5 mm,
**and/ or wherein** the height (h₁) of the gap formed between the web (2) and the material outlet side (29) of the depositing head (30) is larger than 0.05 mm, preferably larger than 0.1 mm **and/ or wherein** the height (h₂) of the gap formed between the web (2) and the acoustic levitation device (17) is smaller than 1 mm, preferably smaller than 0.5 mm, and/or
larger than 0.5 mm, preferably larger than 1 mm,
**and/ or wherein** the height (h₃) of the gap formed between the material outlet side (29) of the depositing head (30) and the acoustic levitation device (17) is smaller than 0.2mm, preferably smaller than 0.1mm, and/or larger than 0.02 mm, preferably larger than 0.05mm.

16. Method according to claim 14 or 15, **wherein** the acoustic wave generator (17) is controlled independently of the transport system (4) and/or independently of the depositing head (30), particularly independently of the material type and/or material flow out of the material outlet side (29) of the depositing head (30).
